# EUROPEAN PATENT APPLICATION

(11) **EP 2 690 447 A2**
(43) Date of publication of application: **29.01.2014**
(21) Application number: 13177051.3
(22) Date of filing: 18.07.2013
(51) Int. Cl.: G01R 1/067

(54) **Inspection jig and contact**

(30) Priority: 25.07.2012 JP 2012164395
(71) Applicant: Nidec-Read Corporation, Kyoto-shi, Kyoto 615-0854 (JP)
(72) Inventor: Numata, Kiyoshi, Kyoto, 615-0854 (JP); Yamamoto, Masami, Kyoto, 615-0854 (JP); Kim, Sukkwi, Kyoto, 615-0854 (JP)
(74) Representative: Viering, Jentschura & Partner

(57) **Abstract**

A contact that can maintain the function of a spring portion even under relatively high current conditions, and an inspection jig equipped with the contact are provided. A contact (50) of an inspection jig (10) includes a columnar portion (52) and a cylindrical portion (54) disposed around the columnar portion (52). The columnar portion (52) includes a front end portion (52f) protruding from the cylindrical portion (54), and a rear end portion (52r). The cylindrical portion (54) has a spring portion (54s), and the spring portion (54s) is configured to expand and compress to change a dimension between the front end portion (52f) of the columnar portion (52) and the rear end portion of the cylindrical portion (54). The cylindrical portion (54) is formed of an alloy of nickel (Ni) and phosphorus (P).

## Description

The present invention relates to an inspection jig that electrically connects an inspection apparatus or the like to inspection points that are preset on an inspection target, and a contact used in such an inspection jig. The contact according to the present invention is not limited to being connected to an inspection apparatus and may also be used to electrically connect two predetermined points.

### [Background Art]

Inspection using an inspection apparatus is performed in order to ensure accurate transmission of electrical signals through wiring formed on a printed circuit board. The inspection apparatus measures electrical properties such as resistance values between inspection points provided on the wiring of the printed circuit board and determines the quality of the wiring before installation of electrical and electronic components. Such an inspection apparatus uses an inspection jig including a plurality of contacts (e.g., connection terminals, probes, explorers, or contact pins). The inspection apparatus supplies current or electrical signals to inspection points that are set on an inspection target and detects electrical signals from the inspection points via the contacts, so as to detect electrical properties between the inspection points and carry out performance tests or the like such as continuity checks or leakage checks.

In the case of inspecting a substrate using the inspection apparatus, control is performed such that the contacts of the inspection jig are moved by jig moving means into abutment with inspection points set on the substrate to be inspected, and when the inspection ends, the contacts of the inspection jig are moved by the jig moving means from the inspection points to standby positions.

The contacts for use in the inspection jig can be appropriately selected from any contact exhibiting conductivity that enables exchange of predetermined electrical signals with inspection points. Examples of the contacts are disclosed in Patent Literatures (PTLs) 1 to 6 described below.

PTL 1 discloses forming contact pins of a clad wire, with the wire having an interior made of palladium and an outer peripheral portion made of beryllium copper. PTL 2 discloses a contact needle formed by coating a tungsten wire with a Ni plating layer and coating only a tip portion with a Ni-B plating layer containing PTFE.

PTL 3 discloses a conductive contact including a pointed conductive needle-like body and a compression coil spring. PTL 4 discloses a contact including a helical spring portion, and a contact holder for holding the contact. PTL 5 discloses a contact pin using either a Au-Ag based alloy or a Be-Cu based alloy as a core and using SUS304 as an outer coating material. PTL 6 discloses a contact for a current inspection jig having a spring structure.

### [Citation List]

[Patent Literature]
[PTL1] JP 2001-337110A
[PTL 2] JP 2003-167003A
[PTL 3] JP 2003-014779A
[PTL 4] J P 2008-164351 A
[PTL 5] J P 2005-037381 A
[PTL 6] Japanese Patent No. 4572303

### [Summary of Invention]

### [Problem to be Solved by Invention]

The inventors of the present application conducted electrical load tests using contacts each including a columnar portion (core) and a cylindrical portion disposed on the outer side of the columnar portion and having a spring portion. Tungsten was used as the material for the core, and nickel (Ni) was used as the material for the cylindrical portion. It was found that when a relatively high current of approximately 1A was applied using these contacts, the temperature of the contacts increased, making the spring portion susceptible to degeneration and plastic deformation due to the high temperature, and causing the spring portion to deteriorate. After serious consideration and study of this problem, the inventors of the present application succeeded in finding a contact structure that can maintain the function of the spring portion even when a relatively high current of approximately 1A, for example, is applied thereto.

It is thus an object of the present invention to provide a contact that can maintain the function of a spring portion even under relatively high current conditions and to provide an inspection jig including such contacts.

### [Solution to Problem]

In order to solve the above-described problem, an inspection jig according to a first aspect of the present invention includes a contact, an electrode portion including a conductor that is electrically connected to the contact, a head portion for guiding the contact to a predetermined inspection point of an inspection target, and a base portion for guiding the contact to the conductor of the electrode portion. The contact includes a columnar portion and a cylindrical portion disposed around the columnar portion, the columnar portion having a front end portion protruding from the cylindrical portion and a rear end portion at the opposite end to the front end portion and covered with the cylindrical portion, and the cylindrical portion having a front end portion and a rear end portion corresponding to the front end portion and the rear end portion, respectively, of the columnar portion, and a spring portion provided between the front end portion and the rear end portion. The front end portion of the cylindrical portion is connected to the columnar portion. The spring portion is configured to expand and compress to change a dimension between the front end portion of the columnar portion and the rear end portion of the cylindrical portion at the opposite end. The cylindrical portion is formed of an alloy of nickel (Ni) and phosphorus (P).

According to a second aspect of the present invention, in the inspection jig of the first aspect described above, the columnar portion includes a core, and a coating portion covering the core and having a higher electrical conductivity than the core.

According to a third aspect of the present invention, in the inspection jig of the first aspect described above, the columnar portion is formed of an alloy of copper (Cu) and silver (Ag).

According to a fourth aspect of the present invention, in the inspection jig of the third aspect described above, the columnar portion has an electrical conductivity of 50 × 10⁶ to 70 × 10⁶ S/m.

According to a fifth aspect of the present invention, in the inspection jig of the second aspect described above, a pointed end of the core exposed on a front end face of the front end portion of the columnar portion of the contact is to come into contact with a predetermined inspection point of the inspection target, and an end face of the rear end portion of the cylindrical portion of the contact is to come into contact with an exposed end face of the electrode portion.

According to a sixth aspect of the present invention, in the inspection jig of either the second or fifth aspect described above, the core is flush with an outer surface of the coating portion at a front end face of the front end portion of the columnar portion of the contact.

According to a seventh aspect of the present invention, in the inspection jig of any one of the second, fifth, and sixth aspects described above, the coating portion is formed of one of or an alloy of metals including gold (Au), silver (Ag), and copper (Cu).

According to an eighth aspect of the present invention, in the inspection jig of any one of the second and fifth to seventh aspects described above, the core is formed of one of metals including tungsten, a tungsten alloy, palladium, and a palladium alloy.

According to a ninth aspect of the present invention, in the inspection jig of any one of the second and fifth to eighth aspects described above, the core has an electrical conductivity of 5 × 10⁶ to 25 × 10⁶ S/m, and the coating portion has an electrical conductivity of 45 × 10⁶ to 70 × 10⁶ S/m.

According to a tenth aspect of the present invention, in the inspection jig of any one of the second and fifth to ninth aspects described above, the coating portion has an electrical conductivity that is at least 2.5 times the electrical conductivity of the core.

According to an eleventh aspect of the present invention, in the inspection jig of any one of the second and fifth to tenth aspects described above, a ratio of an outer diameter of the core to a thickness of the coating portion is in a range of 1:1 to 5:1.

A twelfth aspect of the present invention is a contact for use in an inspection jig for inspecting an electrical property between inspection points. The contact includes a columnar portion, and a cylindrical portion disposed around the columnar portion, the columnar portion having a front end portion protruding from the cylindrical portion and a rear end portion at the opposite end to the front end portion and covered with the cylindrical portion, and the cylindrical portion having a front end portion and a rear end portion corresponding to the front end portion and the rear end portion, respectively, of the columnar portion, and a spring portion provided between the front end portion and the rear end portion. The front end portion of the cylindrical portion is connected to the columnar portion. The spring portion is configured to expand and compress to change a dimension between the front end portion of the columnar portion and the rear end portion of the cylindrical portion at the opposite end. The cylindrical portion is formed of an alloy of nickel (Ni) and phosphorus (P).

In the inspection jig of the present embodiment, the coating portion has an electrical conductivity that is at least 2.5 times the electrical conductivity of the core.

In the inspection jig of this embodiment, the contact has a resistance value of 50 mΩ (milli-ohm) or less.

In the inspection jig of this embodiment, the outer diameter of the core of the contact and the thickness of the coating portion are set so as to enable a current of 1 A to be applied between the front end portion of the columnar portion and the rear end portion of the cylindrical portion at the opposite end.

In the inspection jig of this embodiment, the ratio of the outer diameter of the core to the thickness of the coating portion is set in a range of 1:1 to 5:1.

In the inspection jig of this embodiment, the outer diameter D2 of the columnar portion of the contact is in a range of 20 to 100 µm, the outer diameter D1 of the core of the contact is in a range of 15 to 80 µm, and the thickness h of the coating portion of the contact is in a range of 1 to 20 µm.

In the inspection jig of this embodiment, the base portion has formed therein through holes for inserting the rear end portion of the cylindrical portion of the contact, the head portion has formed therein through holes each consisting of a large-diameter portion in which the front end portion of the cylindrical portion of the contact is to be inserted and a small-diameter portion in which the front end portion of the columnar portion of the contact is to be inserted, and the large-diameter portion and the small-diameter portion form a step therebetween, the step constituting an engagement portion against which the front end face of the cylindrical portion of the contact abuts.

In the inspection jig of this embodiment, a dimension L of the cylindrical portion of the contact is greater than the distance from the engagement portion of the through hole of the head portion to the exposed end face of the electrode portion, and the spring portion of the cylindrical portion of the contact is compressed when the contact is incorporated into the inspection jig. The contact is thus stably held between the head portion and the base portion by the elastic force of the compressed spring portion.

In the inspection jig of this embodiment, the spring portion of the cylindrical portion of the contact is further compressed when a pointed end of the core exposed on the front end face of the front end portion of the columnar portion of the contact is brought into contact with a predetermined inspection point of the inspection target in a state in which the end face of the rear end portion of the cylindrical portion of the contact is in contact with the exposed end face of the electrode portion.

### [Advantageous Effects of Invention]

According to the first to twelfth aspects of the present invention, the cylindrical portion of the contact formed of a nickel-phosphorus alloy can suppress a reduction in function of the spring portion of the cylindrical portion (in particular, a reduction in plastic deformation resistance) due to a rise in temperature of the spring portion and accordingly can improve resistance to a rise in temperature of the spring portion. Consequently, it is possible to provide an inspection jig including a contact that can maintain the function of the spring portion even under relatively high current conditions.

According to the second aspect of the present invention, the core of the columnar portion of the contact is covered with the coating portion having a higher electrical conductivity than the core. Thus, the coating portion can effectively reduce the electrical resistance value of the columnar portion and reduce the amount of heat generated at the columnar portion during the application of current to the contact. Consequently, it is possible to improve the resistance of the contact to the application of high currents while ensuring the mechanical strength of the columnar portion by, for example, selecting a material excellent in mechanical strength (e.g., hardness) as the material for the core.

### [Brief Description of Drawings]

FIG. 1 is a partial cross-sectional front view illustrating a schematic configuration of an inspection jig equipped with contacts according to an embodiment of the invention.
FIG. 2A is a side view illustrating a schematic configuration of a contact according to an embodiment of the invention.
FIG. 2B is a cross-sectional view taken along the center line of the contact illustrated in FIG. 2A according to the embodiment of the invention.
FIG. 3 is a cross-sectional view illustrating a simplified configuration of part of the inspection jig equipped with the contact according to the embodiment of the invention.
FIG. 4A schematically illustrates a columnar portion of the contact according to the embodiment of the invention.
FIG. 4B illustrates a cross-sectional structure of the columnar portion of the contact according to the embodiment of the invention.
FIG. 5 is a graph showing test results on three samples of the contact in FIG. 2A for plastic deformation properties under applied load after current supply.
FIG. 6 is a graph showing test results obtained by the same tests as in FIG. 5 on three samples of a comparative example to the contact in FIG. 2A.
FIG. 7 is a graph showing test results on three samples of the contact in the FIG. 2A and a sample of a comparative example for plastic deformation properties with a temperature rise at the time of load application.
FIG. 8A is a cross-sectional view showing an example of a step of forming a gold (Au) plating layer and a nickel (Ni) plating layer at the stage of manufacturing the cylindrical portion of the contact according to an embodiment of the invention.
FIG. 8B is a cross-sectional view showing an example of a step of forming a resist film at the stage of manufacturing the cylindrical portion of the contact according to the embodiment of the invention.
FIG. 8C is a cross-sectional view showing an example of a step of removing part of the resist film at the stage of manufacturing the cylindrical portion of the contact according to the embodiment of the invention.
FIG. 8D is a cross-sectional view showing an example of a step of etching the Ni plating layer and a step of removing the resist film at the stage of manufacturing the cylindrical portion of the contact according to the embodiment of the invention.
FIG. 8E is a cross-sectional view illustrating a state in which the columnar portions of a plurality of contacts are formed after a step of pulling out a core has ended at the stage of manufacturing the cylindrical portion of the contact according to the embodiment of the invention.

### [Description of Embodiments]

Contacts for use in an inspection jig according to the present embodiment enables detection of electrical properties of an inspection target and execution of a performance test by supplying power or electrical signals from the inspection apparatus to predetermined inspection points of the inspection target and detecting electrical signals from the inspection points.

The contacts according to this embodiment can be used to electrically connect an inspection target and an inspection apparatus and can also be used as inspection jigs such as interposers or connectors that connect electrode terminals.

In the specification of the present application, objects whose electrical properties are measured using an inspection jig are collectively referred to as "inspection targets," and sites that are set in the inspection targets and are brought into a conductive state when the contacts abut against them are simply referred to as "inspection points." Sites between inspection points are referred to as "spaces between inspection points."

Examples of the inspection targets include various types of boards such as printed circuit boards, flexible boards, ceramic multilayer printed circuit boards, electrode plates for liquid crystal displays or plasma displays, package boards for semiconductor packages, and film carriers, and semiconductor devices such as semiconductor wafers, semiconductor chips, chip size packages (CSPs), and large-scale integration (LSI).

When the inspection target is a printed circuit board equipped with a semiconductor circuit such as an IC and electrical and electronic components such as a resistor, wiring formed on the board is inspected. In this case, electrical properties such as resistance values between inspection points, which are points provided on the wiring of the printed circuit board before installation of the electrical and electronic components, are measured to determine the quality of the wiring, in order to ensure that the wiring to be inspected can accurately transmit electrical signals to the electrical and electronic components.

When the inspection target is a liquid crystal panel or a plasma display panel, wiring formed on this glass panel is inspected. In this case, electrical properties such as resistance values between inspection points, which are provided on the wiring of the glass panel, are measured to determine the quality of the wiring, in order to ensure that the wiring can transmit and receive predetermined electrical signals.

When the inspection target is a semiconductor device such as a CSP or a LSI, an electronic circuit formed on the semiconductor device is inspected, and each surface pad of the electronic circuit serves as an inspection point. In this case, electrical properties between inspection points are measured to determine the quality of the electronic circuit, in order to ensure that the LSI or the electronic circuit formed on the LSI has the desired electrical properties.

Hereinafter, an inspection jig equipped with contacts according to an embodiment of the invention will be described with reference to the accompanying drawings.

For better understanding of the accompanying drawings, the thickness, length and shape of each member, the space between members and the like are appropriately enlarged, reduced, deformed, or simplified, for example.

### [Schematic Configuration of Inspection Jig]

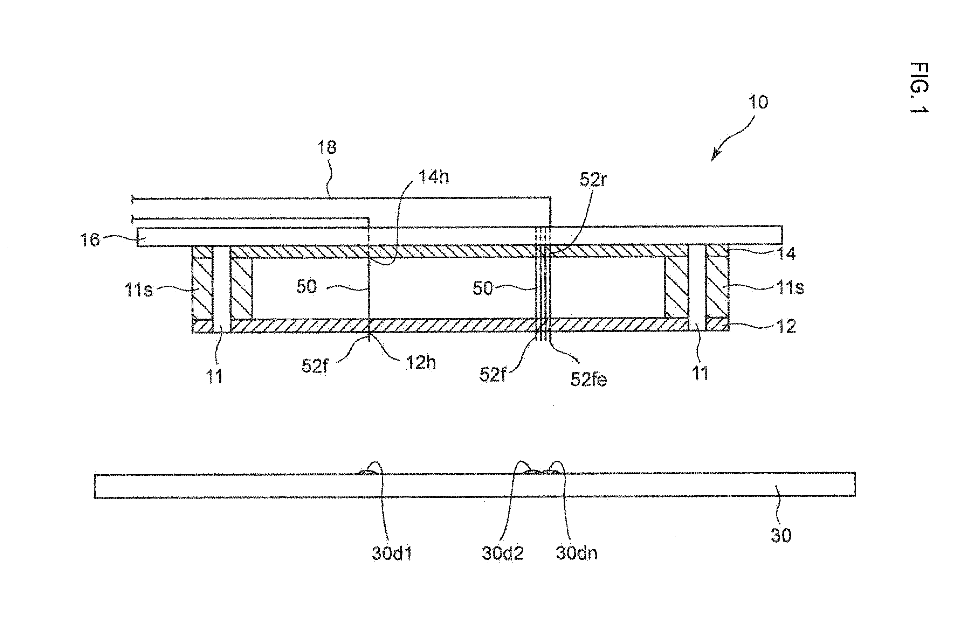

FIG. 1 is a partial cross-sectional front view illustrating a schematic configuration of an inspection jig 10 according to an embodiment of the invention. The inspection jig 10 includes a head portion 12, a base portion 14, and an electrode portion 16. The head portion 12 and the base portion 14 are formed of plate-like insulating members such as resins or ceramic. The head portion 12 and the base portion 14 are held at a predetermined distance away from each other by a rod-like support member 11 and a spacer 11s disposed around the support member 11.

The head portion 12 has formed therein a plurality of through holes 12h for inserting and guiding front end portions 52f of contacts 50 to a predetermined position. The base portion 14 also has formed therein a plurality of through holes 14h for inserting and guiding rear end portions 52r of the contacts 50 to the electrode portion 16.

The rear end portions 52r of the contacts 50 are in contact with the ends of conductors 18 fixed to the electrode portion 16, and the conductors 18 are connected to an inspection apparatus not shown. To simplify the drawing, only some of the contacts 50 are illustrated in FIG. 1.

At the time of inspection, an inspection target 30 is disposed under the inspection jig 10 as shown in FIG. 1, and the inspection jig 10 is moved downward so that the tips of the front end portions 52f of the contacts 50 are brought into contact with predetermined inspection points 30d1, 30d2, and 30dn and accordingly the electrical properties of the inspection target 30 are inspected.

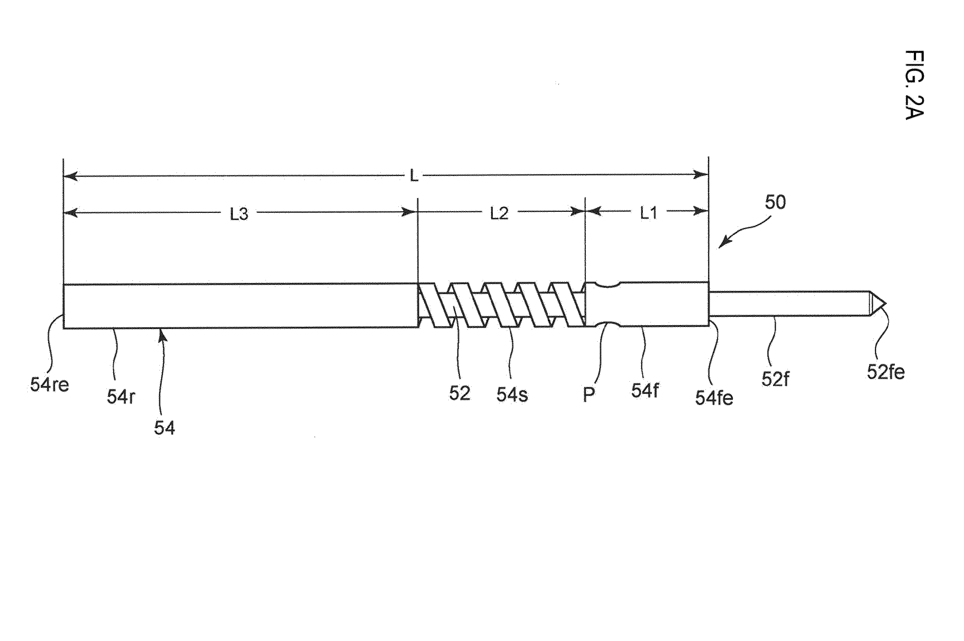

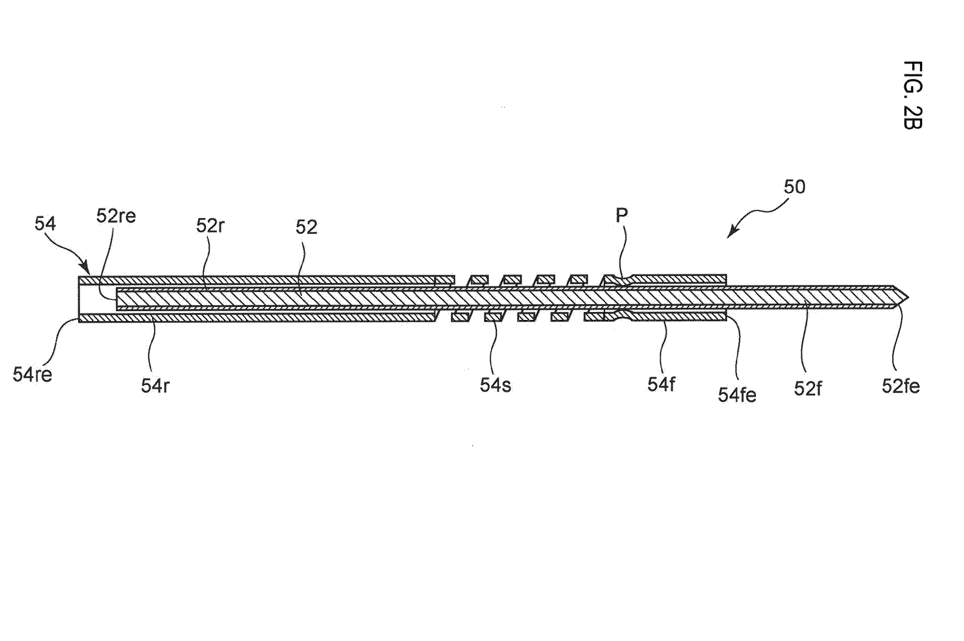

FIGS. 2A and 2B illustrate a contact 50 according to this embodiment. The contact 50 is constituted by a large-diameter cylindrical portion 54 and a small-diameter columnar portion 52 inserted in the cylindrical portion 54. The cylindrical portion 54 and the columnar portion 52 constitute a conductive portion. The cylindrical portion 54 is constituted by a cylinder (tube) of a nickel-phosphorus alloy described later. An insulating coating may be formed on the outer surface of the cylinder (tube) of the cylindrical portion 54.

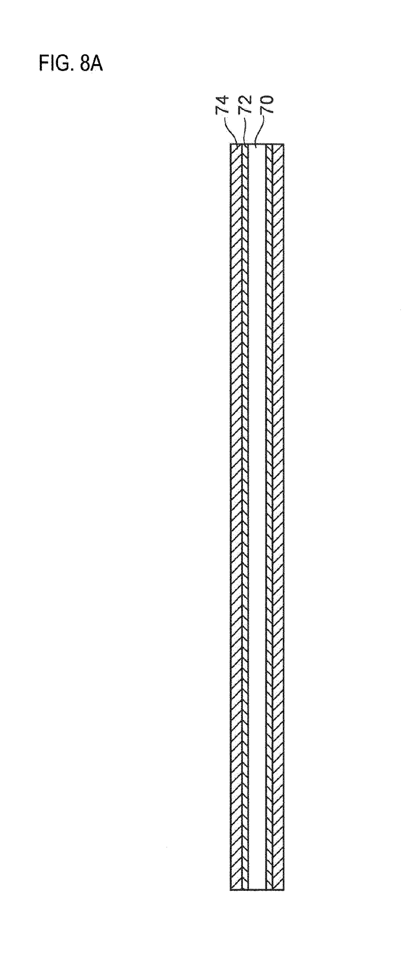

The cylindrical portion 54 includes a front end portion 54f, a rear end portion 54r, and a helical spring portion 54s formed between the front end portion 54f and the rear end portion 54r. Here, L1 is the longitudinal dimension of the front end portion 54f, L2 is the longitudinal dimension (natural length) of the spring portion 54s, L3 is the longitudinal dimension of the rear end portion 54r, and L is the longitudinal dimension (natural length) of the cylindrical portion 54, i.e., L = L1+L2+L3. Although the present example shows the case of providing a single spring portion 54s, the cylindrical portion 54 may include two or more spring portions. In that case, the coils of the two or more spring portions may wind in the same direction or in opposite directions. Although the method for manufacturing the cylindrical portion 54 will be described later in detail with reference to FIGS. 8A to 8E, a method using electroplating or a method using electroless plating can be adopted as the manufacturing method.

The cylindrical portion 54 is formed of a nickel-phosphorus alloy. Nickel-phosphorus alloy refers to nickel mixed with phosphorus. The cylindrical portion 54 formed of a nickel-phosphorus alloy can suppress a reduction in the performance of the spring portion 54s of the cylindrical portion 54 due to a temperature rise (in particular, a reduction in plastic deformation resistance) and accordingly can improve the resistance of the spring portion 54s to a temperature rise.

The phosphorus content (percent by weight) in the nickel-phosphorus alloy is preferably set in a range of, for example, 7 to 15%, and more preferably, in the range of 10 to 12%. The lower limit of the phosphorus content is 7% because a phosphorus content of less than 7% would not have a sufficient effect on the heat resistance of the spring portion 54s. The upper limit of the phosphorus content is 12% because a phosphorus content of higher than 12% would weaken the spring portion 54s, making the spring portion 54s susceptible to plastic deformation when the spring portion 54s is deformed under applied load.

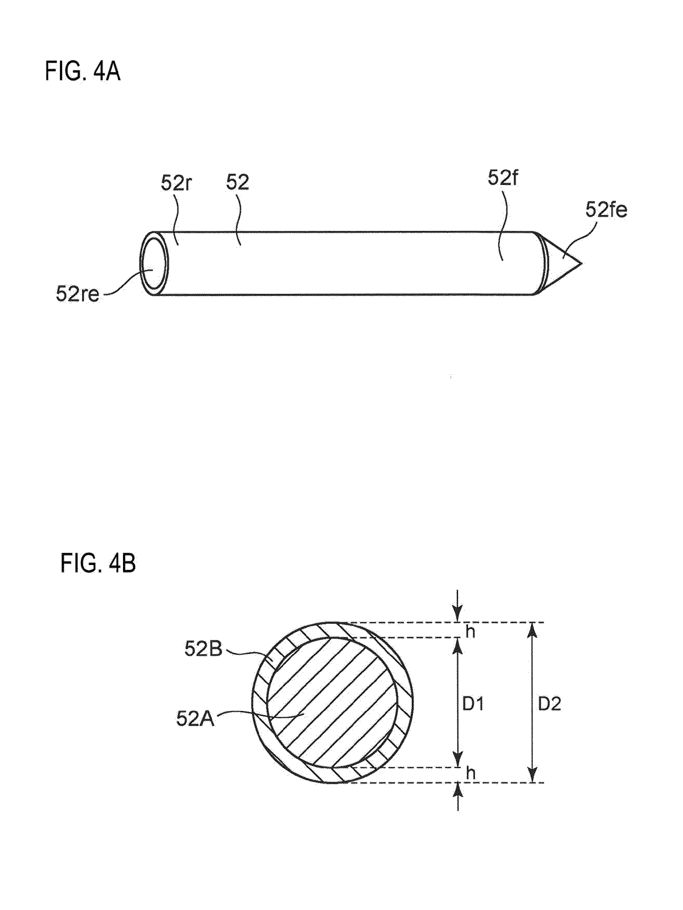

The columnar portion 52 can be constituted by, for example, a core made of tungsten and a coating of copper (Cu), i.e., copper plating, on the outer side of the core. The structure and material of the columnar portion 52 will be described later in detail with reference to FIGS. 4A and 4B. The front end portion 52f of the columnar portion 52 protrudes from the front end portion 54f of the cylindrical portion 54. The front end portion 52f of the columnar portion 52 and a front end face 54fe of the cylindrical portion 54 form a step. The tip of the front end portion 52f of the columnar portion 52 has a pointed front end face 52fe like a pencil. The rear end portion 52r of the columnar portion 52 is retained at a position in front of a rear end face 54re of the rear end portion 54r of the cylindrical portion 54 so that a space is formed between the rear end face 54re of the cylindrical portion 54 and a rear end face 52re of the columnar portion 52.

The front end portion 54f and the columnar portion 52 are joined and fixed to each other by, for example, resistance welding, laser welding, or swaging at a position P of the front end portion 54f of the cylindrical portion 54. Thus, the columnar portion 52 and the front end portion 54f of the cylindrical portion 54 move together as a unit. Meanwhile, the rear end portion 54r of the cylindrical portion 54 can be moved relative to the front end portion 54f of the cylindrical portion 54 by expansion and compression of the spring portion 54s of the cylindrical portion 54. In other words, the rear end portion 54r of the cylindrical portion 54 can move relative to the columnar portion 52.

In this embodiment, the dimension of the cylindrical portion 54 is changed by the expansion and compression of the spring portion 54s of the cylindrical portion 54, and accordingly the entire length of the contact 50 is changed.

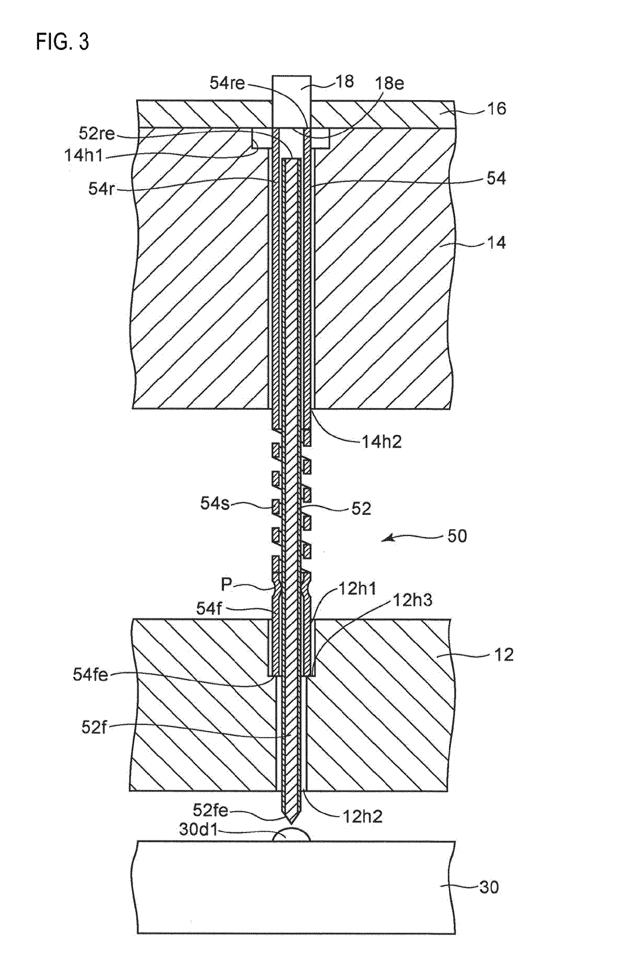

FIG. 3 is a partial cross-sectional view of an inspection jig equipped with the contact 50 illustrated in FIGS. 2A and 2B. As illustrated in Fig. 3, the head portion 12 has formed therein a through hole consisting of a large-diameter portion 12h1 and a small-diameter portion 12h2. The large-diameter portion 12h1 and the small-diameter portion 12h2 form a step therebetween, and this step serves as an engagement portion 12h3 described below. The base portion 14 has formed therein a through hole consisting of a large-diameter portion 14h1 and a small-diameter portion 14h2. An end face 18e of the conductor 18 is exposed at the end face of the electrode portion 16.

The front end portion 54f of the cylindrical portion 54 of the contact 50 is inserted in the large-diameter portion 12h1 of the through hole of the head portion 12, and the front end face 54fe of the cylindrical portion 54 abuts against the engagement portion 12h3 of the through hole of the head portion 12. The front end portion 52f of the columnar portion 52 of the contact 50 is inserted in the small-diameter portion 12h2.

The position P where the cylindrical portion 54 and the columnar portion 52 are joined is preferably above the upper surface of the head portion 12 when the front end portion 54f of the cylindrical portion 54 is inserted in the large-diameter portion 12h1 of the through hole of the head portion 12.

Meanwhile, part of the rear end portion 54r of the cylindrical portion 54 of the contact 50 is inserted in the small-diameter portion 14h2 of the through hole of the base portion 14, and the rear end face 54re abuts against the end face 18e of the conductor 18. The rear end face 52re of the columnar portion 52 is spaced from the end face 18e of the conductor 18.

The dimension (natural length) L of the cylindrical portion 54 of the contact 50 (FIG. 2A) before incorporation of the contact 50 into the inspection jig is greater than the distance from the engagement portion 12h3 of the through hole of the head portion 12 of the inspection jig to the end face 18e of the conductor 18.

Thus, when the contact 50 is incorporated into the inspection jig as illustrated in FIG. 3, the cylindrical portion 54 is pushed by the engagement portion 12h3 and the end face 18e at both ends, and accordingly the spring portion 54s is compressed by the amount of difference in dimension. This compression causes the spring portion to exert a biasing force acting to return to its original length. This biasing force allows the contact 50 to be stably held by the inspection jig.

At the time of inspecting an inspection target using the inspection jig, the inspection jig is moved downward so that the tip of the columnar portion 52 of the contact 50 abuts and pushes against a predetermined inspection point 30d1 on the inspection target 30 such as wiring. This causes the front end portion 52f of the columnar portion 52 of the contact 50 to be pushed into the small-diameter portion 12h2 of the through hole of the head portion 12. Because the columnar portion 52 and the front end portion 54f of the cylindrical portion 54 are joined at the position P, the front end portion 54f of the cylindrical portion 54 is also pushed upward together when the front end portion 52f is pushed upward, pushing the front end face 54fe away from the engagement portion 12h3. This compresses the spring portion 54s of the cylindrical portion 54 and causes the spring portion to exert a biasing force acting to return to its original length. With this biasing force, the tip of the columnar portion 52 is pushed against the inspection point 30d1, and accordingly stable contact can be ensured between the tip of the columnar portion 52 and the inspection point 30d1.

The structure and material of the columnar portion 52 will now be described with reference to FIGS. 4A and 4B. The columnar portion 52 includes the front end portion 52f and the rear end portion 52r. The tip of the front end portion 52f has a pointed front end face 52fe like a pencil. This cone-shaped face 52fe can be formed by, for example, polishing. The rear end portion 52r has the rear end face 52re.

The columnar portion 52 is constituted by a core 52A and a coating portion 52B covering the core 52A. The core 52A may, for example, be a metal having an electrical conductivity ranging from 5 x 10⁶ to 25 x 10⁶ S/m. Specifically, a metal material having higher mechanical strength (e.g., hardness) than the coating portion 52B, such as tungsten (W), a tungsten alloy, palladium (Pd), or a palladium alloy, can be adopted as the core 52A.

The coating portion 52B is formed of a material having a higher electrical conductivity than the core 52A. The coating portion 52B may, for example, be a metal having an electrical conductivity of 45 × 10⁶ to 70 × 10⁶ S/m. More preferably, the coating portion 52B has an electrical conductivity that is at least 2.5 times higher than that of the core 52A. Specific examples of the material for the coating portion 52B include gold (Au), silver (Ag), copper (Cu), and an alloy of any of these metals.

The front end portion 52f of the columnar portion 52 has the pointed front end face 52fe. This front end face 52fe can be formed in, for example, a curved shape, a quadrangular pyramid shape, or a conical shape. FIG. 2A shows a case in which the front end face 52fe in FIG. 2A is formed in a conical shape. The front end face 52fe of the columnar portion 52 is such that the core 52A is exposed protruding from the coating portion 52B, like the core of a pencil. Thus, the core 52A at the tip of the columnar portion 52 abuts against an inspection point. By forming the columnar portion 52 in this way, it is possible to use the hardness of the core 52A and to use the coating portion 52B for the current path.

With the front end face 52fe of the front end portion 52f of the columnar portion 52, it is preferable that the side face of the core 52A and the inclined face (e.g., a convex curved face in the case of a convex shape, or a side face in the case of a quadrangular pyramid shape or a conical shape) of the coating portion 52B forming a pointed shape form a single inclined face without a step.

The columnar portion 52 has an outer diameter D2 of, for example, 20 to 100 µm, the core 52A has an outer diameter D1 of, for example, 15 to 80 µm, and the coating portion 52B has a thickness h of, for example, 1 to 20 µm.

The ratio (D1:h) of the outer diameter D1 of the core 52A to the thickness h of the coating portion 52B is preferably set in the range of 1:1 to 5:1. By setting the ratio in this way, it is possible to effectively reduce the electrical resistance value of the columnar portion 52 while ensuring the mechanical strength of the columnar portion 52 (e.g., the wear resistance of the front end portion of the columnar portion 52) and ensuring the thickness of the coating portion 52B. The columnar portion 52 is thus compatible with, for example, a high current of approximately 1A.

In this embodiment, the coating portion 52B is provided in direct contact with the outer peripheral surface of the core 52A, and therefore a thick coating portion 52B can be formed by plating by accurately controlling the thickness of the coating portion 52B. As a variation, one or a plurality of other conductor layers formed of a conductive metal or the like may be interposed between the core 52A and the coating portion 52B. As another variation, a thin gold plating layer for welding the columnar portion 52 and the cylindrical portion 54 may be provided on the outer surface of the coating portion 52B. In this case, a nickel plating layer is provided between the gold plating layer and the coating portion 52B because it is difficult to apply gold plating to the surface of the coating portion 52B made of copper.

In this way, the core 52A of the columnar portion 52 of the contact 50 is covered with the coating portion 52B having a higher electrical conductivity than the core 52A. The coating portion 52B can thus effectively reduce the electrical resistance value of the columnar portion 52 and can reduce the amount of heat generated in the columnar portion 52 when current is applied to the contact 50. Consequently, it is possible to improve the resistance of the contact 50 to the application of high currents while ensuring the mechanical strength of the columnar portion 52 by, for example, selecting a material excellent in mechanical strength (e.g., hardness), such as tungsten, a tungsten alloy, palladium, or a palladium alloy, as the material for the core 52A.

Moreover, the cylindrical portion 54 of the contact 50 formed of a nickel-phosphorus alloy can suppress a reduction in the performance of the spring portion 54s of the cylindrical portion 54 (in particular, a reduction in plastic deformation resistance) due to a temperature rise and accordingly can improve the resistance of the spring portion 54s to a temperature rise.

As a result, it is possible to provide the inspection jig 10 equipped with the contacts 50 that can maintain the function of the spring portion 54s even under relatively high current conditions.

### [Current Withstanding Capability of Contact]

The inventors of this application measured the current withstanding capabilities of the contact 50 of this embodiment and a contact of a comparative example by applying high currents. The contact of the comparative example has the same dimensions and shape as the contact of this embodiment, but differs in the structure of the columnar portion 52 and the material for the cylindrical portion 54. Specifically, in the comparative example, the columnar portion 52 is constituted by only a tungsten core and does not include a coating portion 52B covering the core. The cylindrical portion 54 in the comparative example is formed of nickel, instead of a nickel-phosphorus alloy.

Here, the dimensions of each portion of the contact 50 of this embodiment and the contact of the comparative example used in the tests are described. The contact 50 of this embodiment and the contact of the comparative example each include the columnar portion 52 having a length of 3 mm and an outer diameter of 50 µm, the cylindrical portion 54 having a length of 2.55 mm, an inner diameter of 54 µm and an outer diameter of 70 µm, and the spring portion 54s having an axial length of 1.62 mm. The amount of protrusion of the front end portion of the columnar portion 52 from the tip of the cylindrical portion 54 when the spring portion 54s is in its natural state is 0.65 mm. With the contact 50 of this embodiment, the ratio of the outer diameter D1 of the core 52A of the columnar portion 52 to the thickness h of the coating portion 52B (copper plating layer) is 3.6:1.

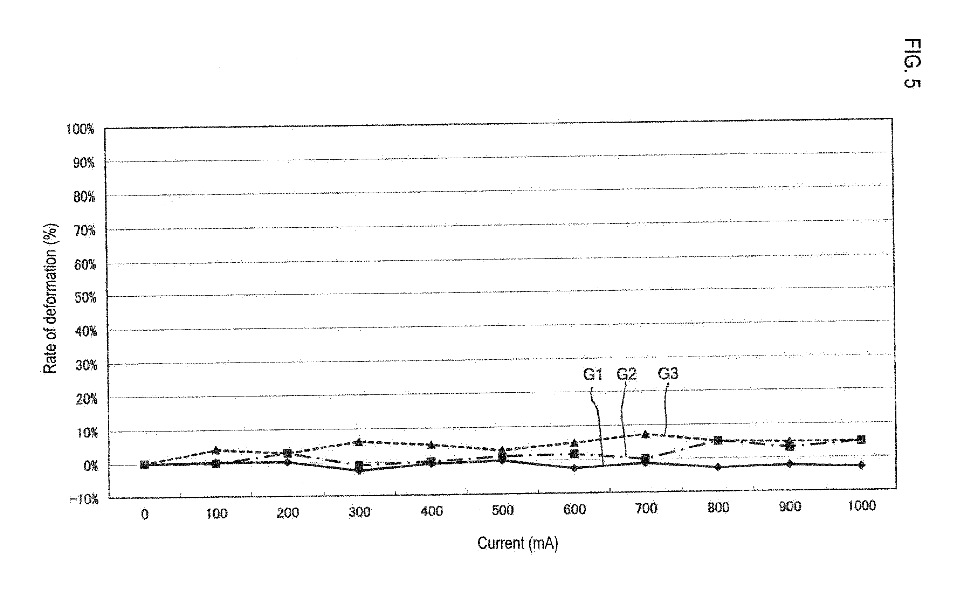

FIG. 5 is a graph showing test results on three samples of the contact 50 of this embodiment for plastic deformation properties under applied load after current supply. Lines G1 to G3 in the graph indicate plastic deformation properties of the respective samples. These three samples have the same configuration, and in each case, the phosphorus content in the nickel-phosphorus alloy constituting the cylindrical portion 54 is set to 11.7%.

In the tests in FIG. 5, a load was applied to each sample after a predetermined current was supplied to the sample, and then the rate of deformation of the contact 50 before and after the application of the load (a value obtained by dividing the amount of reduction in the length of the contact 50 before and after the application of the load by the length of the contact 50 before the application of the load) was obtained on the basis of the change in the length of the sample. The measurement of the rate of deformation involved supplying current to the contact 50 that was being pushed and compressed under a load applied thereto, then removing the load, and measuring the rate of reduction in the length of the contact 50 before and after the application of the load. More specifically, current was supplied to the three samples ten times while increasing the current value in step-wise increments of 100 mA from 100 to 1000 mA, and the rate of deformation was measured for each supply of current. The amount of compression of each sample (or the load applied to each sample) at the time of measuring the rate of deformation was set such that the spring portion 54s of the cylindrical portion 54 was compressed by an amount of compression that is two thirds the maximum amount of compression. Here, the maximum amount of compression is the amount of compression when the spring portion 54s is compressed from its natural state into a state in which adjacent helical coils of the spring portion 54s are brought into close contact with one another. Note that portions of the lines G1 and the like in FIG. 5 where the rate of deformation transitions to zero or below are due to measurement error.

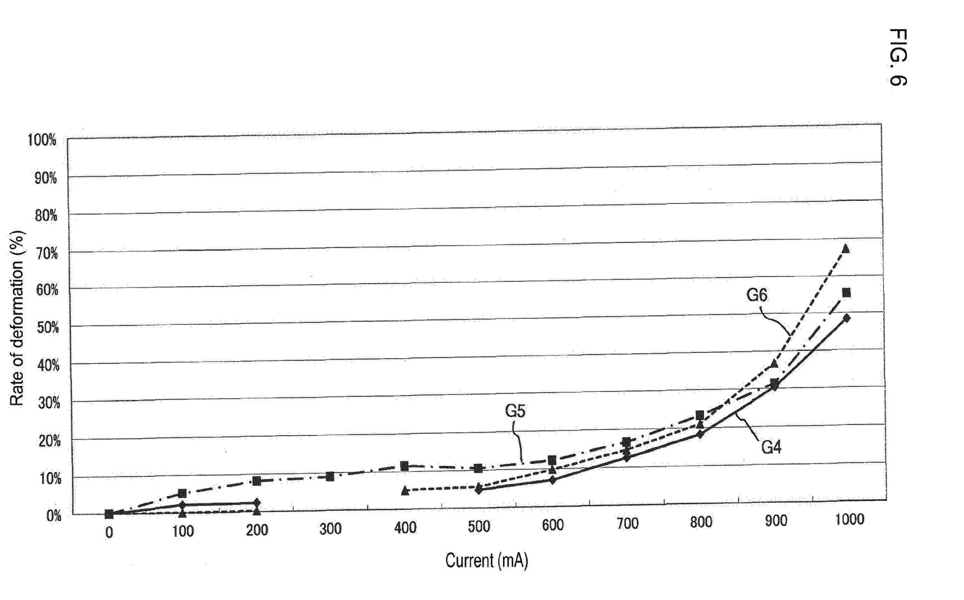

FIG. 6 is a graph showing test results obtained by conducting the same tests as in FIG. 5 on three samples of the comparative example to the contact 50 used in the tests of FIG. 5. Lines G4 to G6 indicate plastic deformation properties of the respective samples. Note that the lines G5 and G4 in FIG. 6 have part of graphic data lost due to some troubles that occurred at the time of acquiring the data.

A comparison between the test results in FIG. 5 and the test results in FIG. 6 indicates that, in the comparative example, the rate of deformation under applied load increases with increasing value of supplied current, and the rate of deformation reaches approximately 50% or more when a current of 1000 mA is supplied, as shown by the graph in FIG. 6. In contrast, the graph in FIG. 5 for the contact 50 according to this embodiment shows that the rate of deformation under applied load is suppressed to less than 10% even if the value of current supplied increases from 100 mA to 1000 mA, and it can be seen that the resistance of the contact 50 to the supply of high currents improves dramatically.

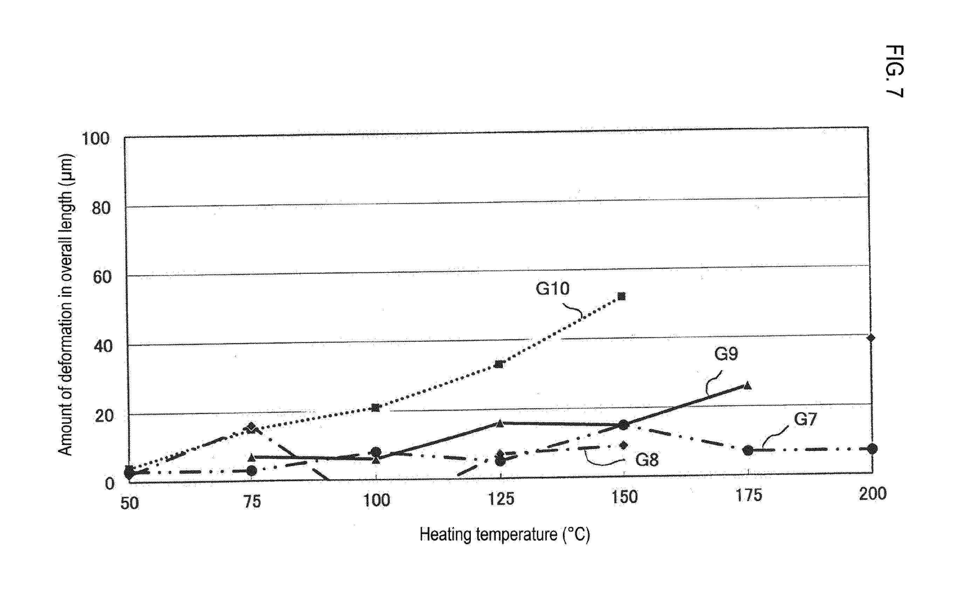

FIG. 7 is a graph showing test results on three samples of the contact 50 of this embodiment and one sample of the comparative example for the plastic deformation properties in relation to a temperature rise under applied load. Lines G7 to G9 correspond to the three samples of the contact 50 of this embodiment, and a line G10 corresponds to the sample of the comparative example. The three samples indicated by the lines G7 to G9 have the same configuration with the exception of the phosphorus content in the nickel-phosphorus alloy constituting the cylindrical portion 54. In the samples indicated by the lines G7 and G8, the phosphorus content in the nickel-phosphorus alloy was set to 11.8%, and in the sample indicated by the line G9, the phosphorus content in the nickel-phosphorus alloy was set to 8.0%. The sample indicated by the line G7 was produced by electroplating, and the samples indicated by the lines G8 and G9 were produced by electroless plating.

In the tests in FIG. 7, each sample was heated to a predetermined temperature in a state in which the spring portion 54s of the cylindrical portion 54 of the sample was being compressed by a predetermined amount under applied load, then the load applied to the spring portion 54s was removed, and then the amount of reduction in the length of the sample before and after compression and heating was measured as the amount of deformation of the spring portion 54s. The measurement of the amount of deformation involved performing heat treatment multiple times while increasing the temperature at the time of heating in a stepwise manner, and measuring the amount of deformation for each heat treatment. In the samples indicated by the lines G7 and G8, heat treatment and measurement of the amount of deformation were performed seven times while increasing the level of temperature rise in increments of 25°C from 50°C to 200°C. In the sample indicated by the line G9, heat treatment and measurement of the amount of deformation were performed five times while increasing the level of temperature rise in increments of 25°C from 75°C to 175°C. The amount of compression of each sample (or the load applied to each sample) for measuring the amount of deformation was set such that the spring portion 54s of the cylindrical portion 54 is compressed by an amount of compression that is two thirds the maximum amount of compression. Note that portions of the line G9 in FIG. 7 where the amount of deformation transitions to zero or below at heating temperatures of approximately 100°C are due to measurement error. Part of graphic data of the lines G8 in FIG. 7 is missing due to problems at the time of data acquisition.

A comparison between the lines G7 to G9 and the line G10 in FIG. 7 reveals that, in the cylindrical portion 54 of the comparative example formed of nickel, the amount of deformation of the spring portion 54s gradually increases with increasingly high heating temperatures (e.g., 100°C or higher) as indicated by the line G10. In contrast, it can be seen that in the cylindrical portions 54 formed of a nickel-phosphorus alloy, an increase in the amounts of deformation of the spring portions 54s is suppressed even at high heating temperatures (e.g., 100°C or higher) as indicated by the lines G7 to G9. Furthermore, the amount of deformation of the spring portion 54s in a high temperature range (e.g., 100°C or higher) is suppressed more with the samples indicated by the lines G7 and G8 where the phosphorus content is 11.7% than with the sample indicated by the line G9 where the phosphorus content is 8.0%.

### [Method for Manufacturing Cylindrical Portion]

Hereinafter, examples of the method for manufacturing the cylindrical portion of a contact will be described.

### [Exemplary Manufacturing Method 1]

(1) First, a core wire (not shown) for forming a hollow portion of the cylindrical portion 54 is prepared. This core wire is a SUS wire of a desired thickness that defines the inner diameter (e.g., approximately 35 µm) of the cylindrical portion 54.
(2) Next, a photoresist coating is applied to the core wire (SUS wire) to cover the peripheral surface of the core wire. A desired portion of the photoresist coating is then subjected to exposure processing, development processing, and heat treatment to form a helical mask. For example, a predetermined portion of the core wire is exposed to laser light by rotating the core wire about the central axis and moving the core wire up and down, so as to form a helical mask. Furthermore, a mask for separation and cutting is formed at both ends of the cylindrical portion, i.e., at positions corresponding to the dimension L of the cylindrical portion.
(3) Then, nickel alloy plating containing phosphorus is applied to the core wire. At this time, nickel alloy plating adheres to an area where the photoresist mask is not formed because the core wire is conductive.
(4) The photoresist mask is then removed and the core wire is pulled out to form a cylindrical portion 54 having an overall length L.

Alternatively, the cylindrical portion 54 can also be manufactured using the following method.

### [Exemplary Manufacturing Method 2]

(1) First, a core wire (not shown) for forming a hollow portion of the cylindrical portion 54 is prepared as in the exemplary manufacturing method 1, and a gold plating layer of a desired thickness and a nickel alloy plating layer of a desired thickness are formed on the outer surface of the core wire.
(2) Next, a photoresist is applied to the surface of the nickel alloy plating layer. A desired portion of the photoresist is then subjected to exposure processing, development processing, and heat treatment to form a helical mask. For example, the core wire is exposed to laser light by rotating the core wire about the central axis and moving the core wire up and down, so as to form a helical mask. Furthermore, a mask for separation and cutting is formed at both ends of the cylindrical portion, i.e., at positions corresponding to the dimension L of the cylindrical portion.
(3) Then, the gold plating and the nickel alloy plating are removed by etching. At this time, the gold plating and the nickel alloy plating in an area where the photoresist mask is not formed are removed.
(4) The photoresist mask is then removed and the core wire is pulled out to form a cylindrical portion 54 having an overall length L.

### [Specific Example of Method for Manufacturing Cylindrical Portion]

FIGS. 8A to 8E are cross-sectional views showing an example of the steps for manufacturing the cylindrical portion 54 of a contact according to an embodiment of the present invention. For better understanding of the drawings, the thickness, length, and shape of each member and the distance or space between members, for example, are appropriately enlarged or reduced in scale, deformed, or simplified. It is assumed that the terms "up," "down," "left," and "right" in the description of the drawings represent directions along the planes of the drawings when a viewer faces the drawings. Although the following describes a case where the cylindrical portion 54 is produced by electroplating, the cylindrical portion 54 may be produced by electroless plating.

FIG. 8A is a cross-sectional view of an electroformed tube (cylindrical tube) manufactured by forming a gold plating layer 72 on the outer surface of a core 70 and forming a nickel alloy plating layer 74 on the gold plating layer 72. The core 70 may be a metal wire or a resin wire that has an outer diameter of, for example, 5 to 300 µm. One example of the metal wire is a SUS wire, and one example of the resin wire is a synthetic resin wire formed of nylon resin, polyethylene resin, or the like. The gold plating layer 72 has a thickness of approximately 0.1 to 1 µm, and the nickel alloy plating layer 74 has a thickness of approximately 5 to 50 µm. The length of the electroformed tube is desirably 50 cm or less from the viewpoint of, for example, facilitating transportation, but is not limited thereto, and the electroformed tube may be manufactured as a continuous tube without being cut.

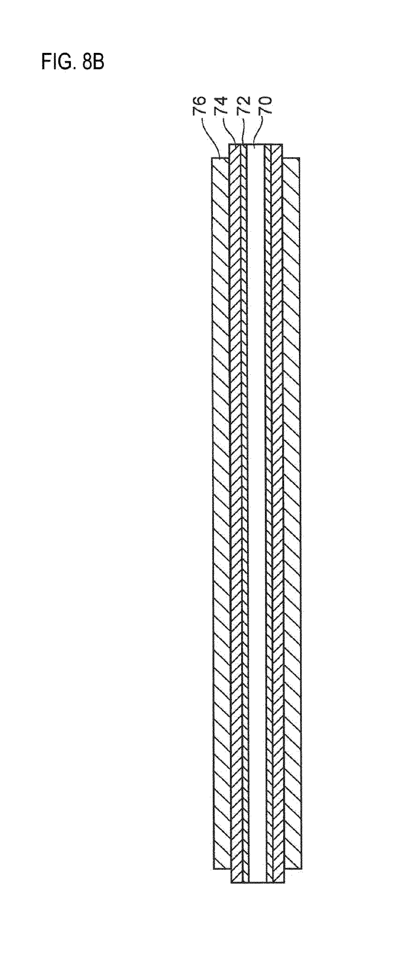

FIG. 8B illustrates a state in which a resist film 76 is formed on the outer surface of the nickel alloy plating layer 74 of the electroformed tube illustrated in FIG. 8A. The resist film 76 has a thickness of approximately 2 to 50 µm. The resist film 76 may be formed of, for example, a fluorine coating or a silicone resin material.

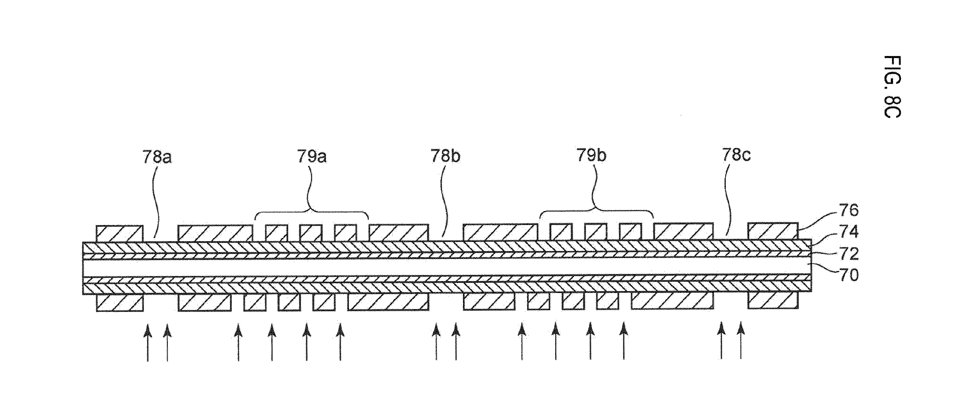

Next, as illustrated in FIG. 8C, the resist film 76 is removed at a predetermined width around the electroformed tube at intervals of, for example, 3 to 30 mm to form grooves 78a, 78b, and 78c. Also, part of the resist film between the grooves is spirally removed to form helical grooves 79a and 79b. Accordingly, the nickel alloy plating layer 74 is exposed in the areas where these grooves are formed.

In the case of forming these grooves, a method for irradiating the resist film 76 with laser beams to remove the resist film 76 can be employed. In this case, laser beams are directly applied to the positions of the grooves while rotating the core 70 in the circumferential direction so as to remove the resist film 76 by the application of laser beams. Note that the output of the laser beams used in this method is able to remove only the resist film 76 and is controlled not to damage the nickel alloy plating layer.

Next, the nickel alloy plating layer 74 exposed in the grooves 78a, 78b, 78c, 79a, and 79b is removed by etching using the resist film 76 as a mask so as to expose the gold plating layer 72. At this time, the presence of the gold plating layer 72 between the nickel alloy plating layer 74 and the core 70 is able to prevent a nickel etchant from reaching the core during etching.

When the nickel alloy plating layer 74 is exposed in the grooves 78a, 78b, 78c, 79a, and 79b, the resist film 76 is removed.

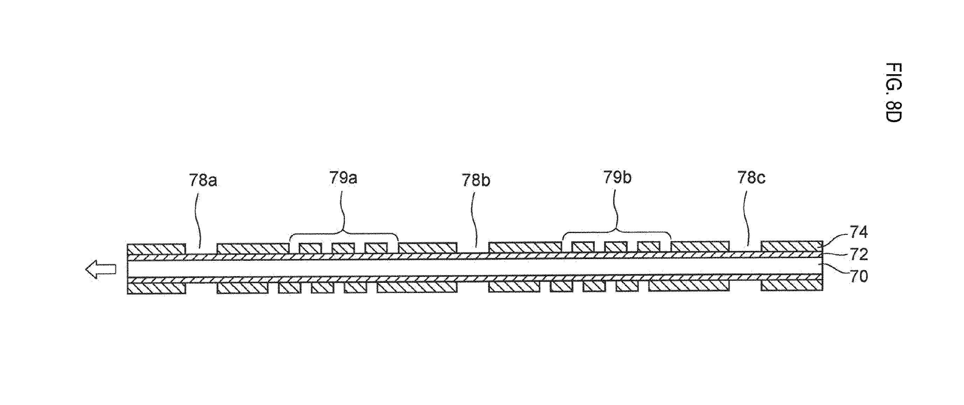

FIG. 8D illustrates a state in which the nickel alloy plating layer 74 is exposed in the grooves 78a, 78b, 78c, 79a, and 79b and the resist film 76 on the nickel alloy plating layer 74 has been removed. Next, the core 70 is deformed to have a smaller cross-sectional area by pulling the opposite ends of the core 70 in the direction away from each other as indicated by the open arrow. At this time, only one end of the core 70 may be pulled with the other end fixed. The core 70 extended to have a smaller cross-sectional area is delaminated from the nickel alloy plating layer 74.

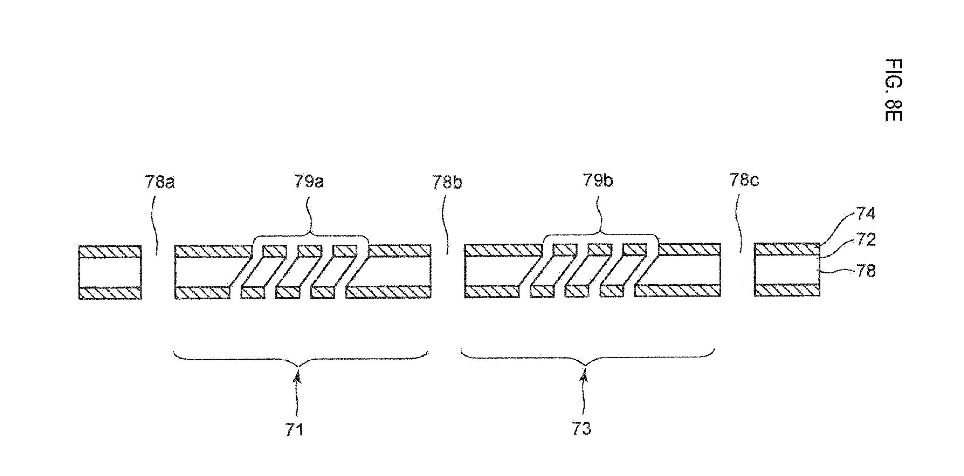

After the core 70 is pulled out, the nickel alloy plating layer 74 remains as illustrated in FIG. 8E. Adjacent portions of the nickel alloy plating layer 74 are separated by the grooves 78a, 78b, and 78c, forming cylindrical portions 71 and 73 as separate pieces. Note that the gold plating layer 72 is removed together with the core 70 when the core 70 is pulled out. In this way, contacts are completed at the stage of pulling out the core 70, without requiring other additional steps. Although FIGS. 8A to FIG. 8E show only part of the electroformed tube in a simplified manner and only two contacts have been manufactured in the step of FIG. 8E, a large number of contacts can be manufactured at one time, using a long electroformed tube.

### [Method for Manufacturing Columnar Portion]

A method for manufacturing the columnar portion 52 according to this embodiment will now be briefly described. In the case of manufacturing the columnar portion 52, a wire material formed of any one of tungsten, a tungsten alloy, palladium, and a palladium alloy is prepared as the core 52A. For example, a tungsten wire material is prepared. At this time, the tungsten wire material has an outer diameter of 20 to 100 µm.

Then, a metal layer serving as the coating portion 52B and having an electrical conductivity that is at least 2.5 times that of the core 52A is plated on the surface of the core 52A. For example, a copper layer is plated on the wire material of tungsten. At this time, the copper plating layer has a thickness of 2 to 20 µm.

Next, the wire material with the metal plating layer formed thereon is formed to a desired length. For example, the copper-plated wire material of tungsten is formed to the desired length. Here, the desired length is approximately equal to the length of the columnar portion 52.

The wire material of the desired length is then disposed so that the core 52A and the coating portion 52B are concentric, and the core 52A and the coating portion 52B that are concentrically arranged thus appear at the both end faces of the wire material. Specifically, for example, a tungsten wire material (core 52A) and a copper plating layer (coating portion 52B) disposed concentric to the wire material are formed.

One end of this wire material is then processed into a pointed shape. For example, the tungsten wire material coated with copper is polished so that its front end face 52fe is processed into a cone shape. At this time, the front end face 52fe is such that a two-layered surface is formed with the tungsten and the copper being flush with each other. The columnar portion 52 can be manufactured through the steps described above.

The cylindrical portion 54 and the columnar portion 52 of the contact according to this embodiment can be manufactured under the above-described dimensional conditions. In particular, a contact having an outer diameter of 30 to 100 µm can be favorably used in an inspection jig.

The present invention is able to provide a contact having a resistance value of 50 mΩ (milli-ohm) or less even when the length of the actual contact is 3 to 4 mm. A contact having such a length and a low resistance value can be favorably used without losing its properties as a contact even if a 1A current is applied.

Although the above embodiment describes a configuration in which the columnar portion 52 of the contact 50 includes the core 52A and the coating portion 52B covering the core 52A, the columnar portion 52 may be formed of a single conductive material (e.g., an alloy of copper (Cu) and silver (Ag)). In this case, the electrical conductivity of the columnar portion 52 is preferably in a range of 50 × 10⁶ to 70 × 10⁶ S/m. Forming the columnar portion 52 of a single conductive material in this way makes it possible to simplify the configuration of the contact 50 and to reduce the manufacturing cost.

While the above has been a description of an inspection jig for inspecting an inspection target and a contact used in the inspection jig according to the present invention, the present invention is not intended to be limited to the above-described embodiment. It is to be understood that the present invention encompasses addition, deletion, and modifications apparent to those skilled in the art, and that the technical scope of the present invention is defined by the appended claims.

### [Reference Signs List]

- 10: Inspection jig
- 11: Support member
- 11s: Spacer
- 12: Head portion
- 12h1: Large-diameter portion of through hole
- 12h2: Small-diameter portion of through hole
- 12h3: Engagement portion
- 14: Base portion
- 14h1: Large-diameter portion of through hole
- 14h2: Small-diameter portion of through hole
- 16: Electrode portion
- 18: Conductor
- 18e: End face
- 30: Inspection target
- 30d1, 30d2, 30dn: Inspection point
- 50: Contact
- 52: Columnar portion
- 52A: Core
- 52B: Coating portion
- 52f: Front end portion
- 52fe: front end face
- 52r: Rear end portion
- 52re: Rear end face
- 54: Cylindrical portion
- 54f: Front end portion
- 54fe: Front end face
- 54r: Rear end portion
- 54re: Rear end face
- 54s: Spring portion
- 70: Core
- 71, 73: Cylindrical portion
- 72: Gold plating layer
- 74: Nickel alloy plating layer
- 76: Resist film
- 78a, 78b, 78c, 79a, 79b: Groove

## Claims

1. A contact for use in an inspection jig for inspecting an electrical property between inspection points, comprising:
a columnar portion; and
a cylindrical portion disposed around the columnar portion,
the columnar portion having a front end portion protruding from the cylindrical portion and a rear end portion at the opposite end to the front end portion and covered with the cylindrical portion, and
the cylindrical portion having a front end portion and a rear end portion corresponding to the front end portion and the rear end portion, respectively, of the columnar portion, and a spring portion provided between the front end portion and the rear end portion,
wherein the front end portion of the cylindrical portion is connected to the columnar portion,
the spring portion is configured to expand and compress to change a dimension between the front end portion of the columnar portion and the rear end portion of the cylindrical portion at the opposite end, and
the cylindrical portion is formed of an alloy of nickel (Ni) and phosphorus (P).

2. An inspection jig comprising:
a contact according to claim 1;
an electrode portion including a conductor that is electrically connected to the contact;
a head portion for guiding the contact to a predetermined inspection point of an inspection target;
and
a base portion for guiding the contact to the conductor of the electrode portion.

3. The inspection jig according to claim 2, wherein
the columnar portion includes a core, and a coating portion covering the core and having a higher electrical conductivity than the core.

4. The inspection jig according to claim 2, wherein
the columnar portion is formed of an alloy of copper (Cu) and silver (Ag).

5. The inspection jig according to claim 4, wherein
the columnar portion has an electrical conductivity of 50 × 10⁶ to 70 × 10⁶ S/m.

6. The inspection jig according to claim 3, wherein
a pointed end of the core exposed on a front end face of the front end portion of the columnar portion of the contact is to come into contact with a predetermined inspection point of the inspection target,
and
an end face of the rear end portion of the cylindrical portion of the contact is to come into contact with an exposed end face of the electrode portion.

7. The inspection jig according to claim 3 or 6, wherein
the core is flush with an outer surface of the coating portion at a front end face of the front end portion of the columnar portion of the contact.

8. The inspection jig according to any one of claims 3, 6 and 7, wherein
the coating portion is formed of one of or an alloy of metals including gold (Au), silver (Ag), and copper (Cu).

9. The inspection jig according to any one of claims 3 and 6 to 8, wherein
the core is formed of one of metals including tungsten, a tungsten alloy, palladium, and a palladium alloy.

10. The inspection jig according to any one of claims 3 and 6 to 9, wherein
the core has an electrical conductivity of 5 × 10⁶ to 25 × 10⁶ S/m, and
the coating portion has an electrical conductivity of 45 × 10⁶ to 70 × 10⁶ S/m.

11. The inspection jig according to any one of claims 3 and 6 to 10, wherein
the coating portion has an electrical conductivity that is at least 2.5 times the electrical conductivity of the core.

12. The inspection jig according to any one of claims 3 and 6 to 11, wherein
a ratio of an outer diameter of the core to a thickness of the coating portion is in a range of 1:1 to 5:1.
